(19) Europäisches Patentamt / European Patent Office / Office européen des brevets

(11) **EP 2 502 288 B1**

(12) **FASCICULE DE BREVET EUROPEEN**

(45) Date de publication et mention de la délivrance du brevet:
**06.08.2014 Bulletin 2014/32**

(21) Numéro de dépôt: **10801593.4**

(22) Date de dépôt: **16.11.2010**

(51) Int Cl.:
*H01L 35/30* $^{(2006.01)}$     *C01B 3/38* $^{(2006.01)}$

(86) Numéro de dépôt international:
**PCT/FR2010/000769**

(87) Numéro de publication internationale:
**WO 2011/061419 (26.05.2011 Gazette 2011/21)**

(54) **GÉNÉRATEUR ÉLECTRIQUE PAR EFFET THERMOÉLECTRIQUE AVEC MISE EN OEUVRE DE DEUX RÉACTIONS CHIMIQUES, EXOTHERMIQUE ET ENDOTHERMIQUE, POUR RESPECTIVEMENT GÉNÉRER ET DISSIPER DE LA CHALEUR**

STROMGENERATOR MIT NUTZUNG DES THERMOELEKTRISCHEN EFFEKTS UND ZWEI CHEMISCHEN REAKTIONEN, EINER EXOTHERMEN UND ENDOTHERMEN REAKTION, ZUR ERZEUGUNG BZW. ABLEITUNG VON WÄRME

ELECTRICAL GENERATOR USING THE THERMOELECTRIC EFFECT AND TWO CHEMICAL REACTIONS, I.E. EXOTHERMIC AND ENDOTHERMIC REACTIONS, TO GENERATE AND DISSIPATE HEAT, RESPECTIVELY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.11.2009 FR 0905537**

(43) Date de publication de la demande:
**26.09.2012 Bulletin 2012/39**

(73) Titulaire: **Commissariat à l'Énergie Atomique et aux Énergies Alternatives 75015 Paris (FR)**

(72) Inventeurs:
• **CAROFF, Tristan 38610 Gières (FR)**
• **CORONEL, Philippe F-38530 Barraux (FR)**
• **GRUSS, Jean-Antoine F-38170 Seyssinet-Pariset (FR)**
• **PLISSONNIER, Marc F-38320 Eybens (FR)**

(74) Mandataire: **Talbot, Alexandre et al Cabinet Hecké Europole 10, rue d'Arménie - BP 1537 38025 Grenoble Cedex 1 (FR)**

(56) Documents cités:
**US-A1- 2003 072 699     US-A1- 2008 113 233 US-B1- 6 313 393**

EP 2 502 288 B1

**Description**

**Domaine technique de l'invention**

L'invention concerne un générateur électrique par effet thermoélectrique comprenant au moins :

- une source de chaleur, siège d'une réaction chimique exothermique et comprenant des moyens d'alimentation en au moins un réactif de ladite réaction chimique exothermique,
- un dissipateur de chaleur, siège d'une réaction chimique endothermique et comprenant des moyens d'évacuation d'au moins un produit de la réaction chimique endothermique,
- et un convertisseur thermoélectrique muni d'au moins deux zones respectivement en contact avec la source de chaleur et le dissipateur de chaleur.

L'invention concerne également un procédé de mise en oeuvre d'un tel générateur électrique par effet thermoélectrique.

L'invention concerne également un procédé de fabrication d'un tel générateur.

**État de la technique**

Actuellement, de gros efforts sont entrepris pour développer des générateurs électriques transportables.

Une des voies possibles pour réaliser un générateur électrique transportable consiste à utiliser un convertisseur thermoélectrique, c'est-à-dire un dispositif basé sur le principe de la conversion d'une énergie thermique en énergie électrique, par effet Seebeck.

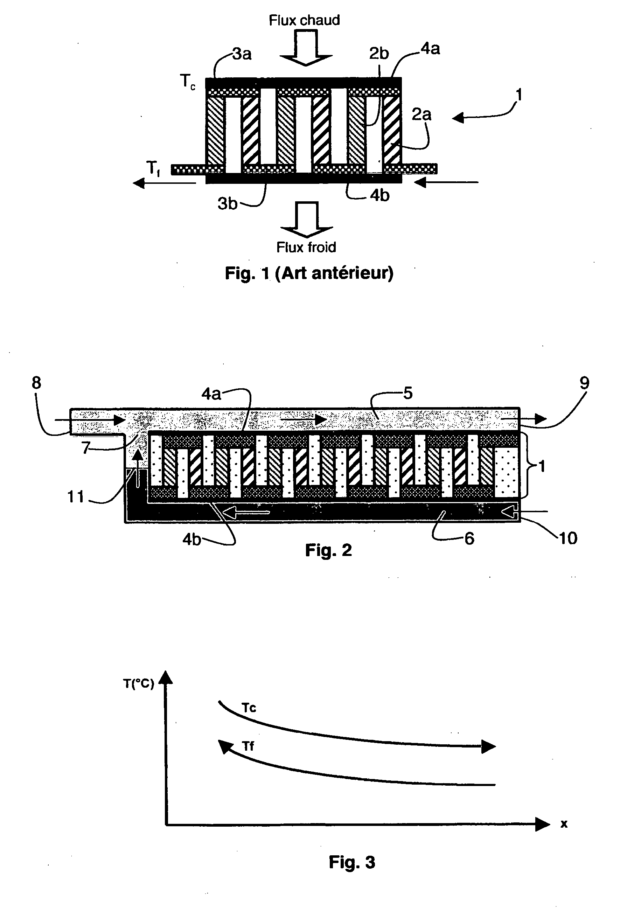

En particulier, comme représenté sur la figure 1, un tel convertisseur 1 comporte un module formé par une série de plusieurs couples connectés électriquement en série et thermiquement en parallèle.

Chacun des couples est, en particulier, constitué d'un thermoélément 2a, formé par un matériau conducteur ou semi-conducteur présentant un coefficient Seebeck positif, et d'un thermoélément 2b, formé par un matériau conducteur ou semi-conducteur présentant un coefficient Seebeck négatif. Les thermoéléments 2a et 2b sont joints deux par deux par des jonctions 3a (jonctions côté chaud) ou 3b (jonctions côté froid), formées par un matériau conducteur électriquement, afin d'obtenir une connexion électrique en série desdits thermoéléments. De plus, les thermoéléments 2a et 2b composant le module sont connectés thermiquement en parallèle afin d'optimiser le flux thermique traversant le module depuis sa première face 4a vers sa seconde face 4b ainsi que sa résistance électrique, grâce à l'application d'un gradient thermique ($\Delta T = T_c - T_f$) depuis la face 4a vers la face 4b. Un tel flux thermique entraîne alors un déplacement des porteurs de charge et donc l'apparition d'un courant électrique I.

En particulier, lorsque les thermoéléments 2a et 2b présentent un coefficient Seebeck respectivement positif (noté $S_{2a}$) et négatif ($S_{2b}$), leur coefficient Seebeck s'additionne et la différence de potentiel V pour le module répond à la formule suivante :

$$V = N \times (S_{2b} - S_{2a}) \times \Delta T = N \times S_{np} \times \Delta T$$

où:

- N correspond au nombre de couples de thermoéléments 2a et 2b dans un module,
- $\Delta T$ correspond au gradient thermique ($T_c - T_f$) appliqué entre les deux faces 4a et 4b du convertisseur thermoélectrique, également appelées zones chaude et froide du convertisseur et
- $S_{np}$ correspond au coefficient Seebeck différentiel entre les thermoéléments 2a et 2b.

La puissance maximale délivrée par un tel convertisseur thermoélectrique, pour une charge résistive égale à la résistance interne du convertisseur $r_{int}$, répond à la formule (1) suivante :

$$P_{\max} = \frac{S_{np}^2 \times (T_c - T_f)^2}{2 \times r_{\text{int}}} \quad (1)$$

où $T_c$ et $T_f$ sont respectivement la température de la zone chaude et de la zone froide du convertisseur.

Par ailleurs, le rendement idéal d'un tel convertisseur correspond au rapport de la puissance électrique utile délivrée à une résistance de charge r égale à la résistance interne du convertisseur, au flux thermique traversant le matériau. Il répond, en particulier, à la formule (2) ci-dessous :

$$\eta = \frac{T_c - T_f}{T_c} \frac{\sqrt{1 + ZT_m} - 1}{\sqrt{1 + ZT_m} + \frac{T_f}{T_c}} \quad (2)$$

avec $T_m = \frac{T_c + T_f}{2}$ et $ZT_m$ et $ZT_m$ correspondant à un coefficient appelé « facteur de mérite » directement dépendant des propriétés électriques et thermiques des matériaux thermoélectriques utilisés pour constituer les thermoéléments 2a et 2b.

Les équations (1) et (2) montrent alors que la puissance et le rendement des convertisseurs thermoélectriques sont directement liés au gradient thermique ($\Delta T = T_c - T_f$) appliqué entre les deux faces du convertisseur thermoélectrique. Ainsi, dans tout système de type convertisseur thermoélectrique, l'existence d'un gradient thermique est donc déterminante pour ses performances et notamment pour obtenir une bonne efficacité énergétique.

Le gradient thermique appliqué au convertisseur thermoélectrique dépend, en particulier, de la source de chaleur utilisée pour maintenir la face 4a du convertisseur thermoélectrique à une température dite chaude $T_c$ et du dissipateur de chaleur utilisé pour maintenir la face 4b du convertisseur thermoélectrique à une température dite froide $T_f$.

Pour la source de chaleur, il a été proposé d'exploiter la chaleur produite par une réaction chimique exothermique comme la combustion catalytique de l'hydrogène ou d'un autre combustible tel que le butane, le propane ou l'éthylène. La chaleur produite permet alors de maintenir la face 4a du convertisseur thermoélectrique à une température $T_c$ suffisamment élevée.

Par contre, pour obtenir un gradient thermique suffisamment élevé pour garantir des performances énergétiques élevées, le système permettant d'évacuer la puissance thermique accumulée par le convertisseur thermique, du côté froid de celui-ci, doit être performant afin d'obtenir une température $T_f$ très inférieure à $T_c$ ($\Delta T > 200°C$ à l'équilibre thermique). Or, les solutions performantes en termes de refroidissement actuellement utilisées sont volumineuses et consomment une partie ou la totalité de l'énergie produite par le convertisseur thermoélectrique. Cela explique les faibles densités de puissance et le faible rendement énergétique global des systèmes existants : énergie perdue dans les ventilateurs, dans un système à circulation d'eau ou de fluide réfrigérant ou bien dans la production d'un fluide réfrigérant et de combustible.

À titre d'exemple, le brevet US6313393 propose un générateur de puissance électrique utilisant une architecture microstructurée pour améliorer le transfert de chaleur. Un tel générateur comporte une chambre de combustion sous forme d'un microcanal, pour réaliser la source de chaleur. La chambre est en particulier le siège d'une réaction chimique exothermique d'un combustible. La chaleur dégagée par la réaction chimique est ensuite transférée à un dispositif destiné à convertir l'énergie thermique en un courant électrique, qui peut être ensuite transmis en dehors du dispositif par des fils de sortie. Puis, le flux thermique une fois celui-ci passé à travers le dispositif est récupéré par un dissipateur de chaleur. Celui-ci peut être, par exemple, formé par un désorbeur thermique, un système présentant des microcanaux pour le passage d'un fluide réfrigérant afin de former un échangeur de chaleur, un réacteur microchimique, siège d'une réaction chimique endothermique.

US 2008/113233 décrit un dispositif de réaction.

## Objet de l'invention

L'invention a pour but de proposer un générateur électrique par effet thermoélectrique présentant des performances énergétiques améliorées par rapport à l'état de la technique.

En particulier, l'invention a pour but un générateur électrique par effet thermoélectrique comprenant un convertisseur thermoélectrique auquel un gradient thermique élevé peut être appliqué sans que les performances énergétiques globales du générateur électrique ne soient dégradées, tout étant suffisamment compact et facile à mettre en oeuvre.

Selon l'invention, ce but est atteint par le fait qu'un générateur électrique par effet thermoélectrique comprenant au moins :

- une source de chaleur, siège d'une réaction chimique exothermique et comprenant des moyens d'alimentation en au moins un réactif de ladite réaction chimique exothermique,

- un dissipateur de chaleur, siège d'une réaction chimique endothermique et comprenant des moyens d'évacuation d'au moins un produit de la réaction chimique endothermique,
- et un convertisseur thermoélectrique muni d'au moins deux zones respectivement en contact avec la source de chaleur et le dissipateur de chaleur,

est caractérisé en ce que les moyens d'alimentation de la source de chaleur sont connectés aux moyens d'évacuation du dissipateur de chaleur, ledit produit de la réaction chimique endothermique formant ledit réactif de la réaction chimique exothermique.

Selon l'invention, ce but est également atteint par un procédé de mise en oeuvre d'un tel générateur électrique caractérisé en ce que ledit produit de la réaction chimique endothermique formant ledit réactif de la réaction chimique exothermique est de l'hydrogène.

Ce but est également atteint par un procédé de fabrication d'un tel générateur électrique par effet thermoélectrique, caractérisé en ce qu'il est obtenu par au moins une étape de moulage par injection de poudre, en particulier de dimension nanométrique.

**Description sommaire des dessins**

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- la figure 1 représente, en coupe, un schéma de principe d'un convertisseur thermoélectrique.
- la figure 2 représente en coupe et schématiquement un premier mode de réalisation d'un générateur électrique selon l'invention.
- la figure 3 représente l'évolution des températures respectivement chaude et froide en fonction du cheminement des réactifs dans les canaux du générateur électrique selon la figure 2.
- les figures 4 et 5 représentent respectivement en coupe et de manière schématique des modes de réalisation particuliers de générateur électrique comprenant une pile à combustible couplée au convertisseur thermoélectrique.
- la figure 6 illustre schématiquement et en coupe un second mode de réalisation d'un générateur électrique selon l'invention.
- la figure 7 représente l'évolution des températures respectivement chaude et froide en fonction du cheminement des réactifs dans les canaux du générateur électrique selon la figure 4.
- la figure 8 illustre en vue de dessus une variante de réalisation d'un générateur électrique selon la figure 2.
- la figure 9 représente schématiquement un exemple particulier de réalisation d'un générateur selon l'invention.
- la figure 10 représente l'évolution de la densité de puissance en fonction de la température $T_c$ de la zone chaude pour des exemples de convertisseurs thermoélectriques comprenant des thermoéléments de hauteurs différentes.
- la figure 11 représente l'évolution de la puissance électrique délivrée et du flux endothermique en fonction du débit massique de réactifs liquides pour la réaction chimique endothermique:

**Description de modes particuliers de réalisation**

Selon un mode particulier de réalisation illustré par les figures 2 et 3, un générateur électrique par effet thermoélectrique comporte un convertisseur thermoélectrique 1, tel que celui représenté sur la figure 1.

Le convertisseur thermoélectrique 1 est, de plus, interposé entre une source de chaleur et un dissipateur de chaleur, afin d'obtenir un gradient thermique $\Delta T = T_c - T_f$ entre les deux faces opposées 4a et 4b du convertisseur thermoélectrique 1. Les faces 4a et 4b forment respectivement les zones chaude et froide du convertisseur thermoélectrique 1, chacune soumise à un flux thermique, chaud ($\phi_{chaud}$) pour la zone chaude et froid ($\phi_{froid}$) pour la zone froide.

Sur la figure 2, la source de chaleur et le dissipateur de chaleur sont respectivement formés par des premier et second canaux de circulation 5 et 6, présentant des axes longitudinaux parallèles. De plus, les deux faces opposées 4a et 4b du convertisseur thermoélectrique 1 délimitent respectivement une partie des premier et second canaux de circulation 5 et 6. Par ailleurs, les premier et second canaux de circulation 5 et 6 sont chacun destinés à être le siège d'une réaction chimique : une réaction chimique exothermique pour le premier canal de circulation 5 et une réaction chimique endothermique pour le second canal de circulation 6.

Le premier canal de circulation 5 comporte à une de ses extrémités au moins un orifice d'entrée 7 destiné à alimenter le premier canal de circulation 5 en au moins un réactif de la réaction chimique exothermique. Sur la figure 2, il comporte, également et de manière avantageuse, un orifice d'entrée additionnel 8 disposé à proximité du premier orifice d'entrée 7. Cet orifice d'entrée additionnel 8 est, plus particulièrement, destiné à alimenter le premier canal de circulation 5 en un autre réactif de la réaction chimique exothermique. Le premier canal de circulation 5 comporte enfin à son autre extrémité un orifice de sortie 9 disposé à l'autre extrémité du premier canal de circulation 5.

La réaction chimique exothermique est, avantageusement, une réaction de combustion catalytique de l'hydrogène ($H_2$ ou dihydrogène). Selon cette réaction chimique, l'hydrogène réagit avec de l'oxygène, par exemple fournit par l'air ambiant, afin de produire de l'eau et de la chaleur. La réaction de combustion de l'hydrogène est très énergétique avec un pouvoir calorifique de 140 MJ/Kg. De plus, la température de flamme de cette réaction de combustion peut atteindre plus de 1500°C. Dans certains cas, l'hydrogène peut être remplacé par un autre combustible, tel que le butane. Cependant, l'hydrogène reste le combustible préféré car il présente un pouvoir calorifique supérieur à celui d'un autre combustible. Le butane a un pouvoir calorifique est de 50 MJ/Kg.

En général, une telle réaction est réalisée avec l'aide d'un catalyseur, ce qui permet d'améliorer son rendement. Le catalyseur avantageusement utilisé est du platine, par exemple sous une forme nanométrique telle que du carbone platiné, mais il peut aussi être choisi parmi le ruthénium, le thorium, l'argent, le cuivre, le zinc, un alliage de fer et de palladium, le nickel et le manganèse. A titre d'exemple, le premier canal de circulation 5 peut, par exemple, être formé par une paroi dont la surface interne est recouverte de particules de platine, de dimension micrométrique ou nanométrique. Le revêtement catalytique formé par ces particules de platine peut de plus et de manière avantageuse, présenter une forte porosité, afin d'augmenter la surface de réaction, et donc le rendement de la réaction.

Ainsi, la réaction chimique exothermique se produit à l'intérieur du premier canal de circulation 5, qui forme alors une chambre de combustion catalytique, en faisant circuler à l'intérieur de celui-ci et depuis les orifices d'entrée 7 et 8 vers l'orifice de sortie 9, un mélange réactionnel. Le mélange réactionnel est initialement constitué en majorité d'air et d'hydrogène, puis il s'enrichit progressivement en vapeur d'eau le long du canal de circulation 5 au profit des réactifs initiaux, jusqu'à comprendre au niveau de l'orifice de sortie 9 majoritairement de l'eau voir que de l'eau selon la longueur du premier canal 5. L'eau produite par la réaction chimique exothermique peut avantageusement être récupérée à l'orifice de sortie 9. En particulier, elle peut, selon le type de réaction endothermique, être utilisée en tant que réactif pour la réaction chimique endothermique. Ainsi, la chaleur dégagée le long du premier canal de circulation 5 est décroissante depuis les orifices d'entrée 7 et 8 jusqu'à l'orifice de sortie 9. Ceci est, plus particulièrement, illustré sur la figure 3 qui représente l'évolution de la température $T_c$ correspondant à la température chaude obtenue au niveau de la face 4a du convertisseur thermoélectrique.

Par ailleurs, le second canal de circulation 6 comporte à une de ses extrémités au moins un premier orifice d'entrée 10 destiné à alimenter le second canal de circulation 6 en au moins un réactif de la réaction chimique endothermique. Il comporte également, à son autre extrémité, un orifice de sortie 11, destiné à évacuer le mélange réactionnel de la réaction chimique endothermique et plus particulièrement au moins un produit de la réaction chimique endothermique. Cet orifice de sortie 11 est, par ailleurs, connecté à l'orifice d'entrée 8 du premier canal de circulation 5.

La réaction chimique endothermique est, en effet, choisie de manière à ce qu'au moins un de ses produits forme un des réactifs de la réaction chimique exothermique. En particulier, si la réaction chimique exothermique est une réaction de combustion catalytique de l'hydrogène, la réaction chimique endothermique est choisie parmi les réactions permettant d'obtenir de l'hydrogène, afin que celui-ci, une fois formé, soit redirigé vers l'orifice d'entrée 7 du premier canal de circulation 5.

Il existe plusieurs réactions chimiques endothermiques permettant de produire de l'hydrogène : le reformage de l'éthanol, du méthanol, de l'éthylène glycol, du méthylcyclohexane, du glycérol, de l'hexane, du méthane, ou bien le craquage de l'ammoniac.

Les tableaux 1 et 2 ci-dessous présentent, à titre d'exemple, le bilan énergétique des réactions chimiques endothermiques de reformage à partir de deux composés : le méthanol et le méthylcyclohexane.

| Réaction endothermique : $CH_3\text{-}OH + H_2O \rightarrow 3H_2 + CO_2$ à 200°C | |
|---|---|
| $\Delta_{Hr(g)}$ (J/mol) | 49000 |
| $\Delta_{evap}\ CH_3\text{-}OH$ | 37000 |
| $\Delta_{evap}\ H_2O$ | 44000 |
| $\Delta H$ endothermique (J/mol) | 130000 |
| $Q_{endothermique}$ (J/Kg) | 2600000 |
| $Q_{endothermique}$ (Wh/Kg reactifs) | 722 |

Tableau 1

| Réaction endothermique : $C_7H_{14} \rightarrow 3H_2 + C_7H_8$ à 350 °C | |
|---|---|
| $\Delta_{Hr(g)}$ (J/mol) | 215000 |
| $\Delta_{evap}\,C_7H_{14}$ | 35800 |
| $\Delta H$ endothermique (J/mol) | 250800 |
| $Q_{endothermique}$ (J/Kg) | 2559184 |
| $Q_{endothermique}$ (Wh/Kg reactifs) | 711 |

Tableau 2

De manière préférentielle, la réaction chimique endothermique est une réaction de vaporeformage à partir de méthanol, consistant à faire réagir le méthanol en présence de vapeur d'eau et de chaleur pour produire de l'hydrogène et du dioxyde de carbone. En effet, parmi les différents hydrocarbures, le choix du méthanol présente de nombreux avantages : il est facile à produire, il est peu toxique notamment en comparaison avec l'ammoniac et les autres hydrocarbures. Il se reforme à des températures modérées (typiquement 150-250°C) par rapport aux autres hydrocarbures (majoritairement de 300°C à 600°C) et il présente une grande densité d'énergie endothermique lors de la réaction chimique (évaporation + reformage). Elle absorbe beaucoup d'énergie ($\approx$ 720 KJ/Kg), ce qui permet d'équilibrer les flux thermiques entre les zones chaude et froide du convertisseur thermoélectrique 1.

Par ailleurs, le rendement de la réaction de vaporeformage du méthanol peut être proche de 100%, pour des températures comprises entre 250°C et 300°C, lorsque la réaction est réalisée en présence d'un catalyseur choisi parmi le cuivre, le zinc, l'aluminium, le zirconium et le palladium. Ainsi, le second canal de circulation 6 peut, comme le premier canal de circulation 5, être formé par une paroi dont la surface interne est recouverte de particules de catalyseur, de dimension micrométrique ou nanométrique.

Dans le générateur 1 selon la figure 2, la réaction chimique endothermique se produit à l'intérieur du second canal de circulation 6 en faisant circuler un mélange réactionnel à l'intérieur de celui-ci, depuis l'orifice d'entrée 10 vers l'orifice de sortie 11. Le second canal de circulation 6 forme, ainsi, une chambre de reformage dans le cas d'une réaction chimique endothermique par reformage, par exemple du méthanol. Le mélange réactionnel est, à l'orifice d'entrée 10, constitué en majorité de méthanol et de vapeur d'eau et il s'enrichit progressivement en hydrogène et en dioxyde de carbone le long du second canal de circulation 6 au profit des réactifs initiaux jusqu'à comporter majoritairement au niveau de l'orifice de sortie 9 les produits de la réaction (en fonction de la longueur du second canal de circulation). Ainsi, la quantité de chaleur absorbée le long du second canal de circulation 6 est décroissante depuis l'orifice d'entrée 10 jusqu'à l'orifice de sortie 11, ce qui induit une augmentation de la température le long du second canal de circulation 6. Ceci est, plus particulièrement, illustré sur la figure 3 qui représente l'évolution de la température $T_f$ correspondant à la température dite froide obtenue au niveau de la face 4b du convertisseur thermoélectrique.

Dans le cas d'une réaction de reformage de méthanol ou d'autres hydrocarbures, les réactifs de la réaction chimique endothermique n'ayant pas réagi à l'orifice de sortie 11 peuvent, comme l'hydrogène, être dirigés vers l'orifice d'entrée 7 du premier canal de circulation 5, afin d'y être consommés par combustion catalytique et contribuer au flux de chaleur.

Sur la figure 2, les mélanges réactionnels circulent respectivement dans les premier et second canaux de circulations 5 et 6, selon des directions opposées, ce qui permet comme illustré sur la figure 3 d'optimiser le gradient thermique ($T_c$-$T_f$) le long du cheminement des deux mélanges réactionnels. Le gradient thermique sera ensuite transformé en courant électrique par effet Seebeck grâce au convertisseur thermoélectrique 1. De plus, le gradient thermique obtenu est avantageusement supérieur à 200°C.

Le fait de coupler thermiquement un convertisseur thermoélectrique avec une source de chaleur formant le siège d'une réaction chimique exothermique pour générer le flux chaud et avec un dissipateur de chaleur formant le siège d'une réaction chimique endothermique pour non seulement générer le flux froid mais aussi le réactif de la réaction chimique exothermique, permet d'obtenir un générateur électrique dont les performances, notamment énergétiques, peuvent être améliorées.

Ceci est, en partie, réalisé en choisissant une réaction chimique endothermique particulière, afin qu'au moins un des produits de ladite réaction soit aussi un des réactifs de la réaction chimique exothermique, celui-ci étant alors au moins en partie redirigé depuis le dissipateur de chaleur vers la source de chaleur.

Ainsi, il est possible, avec une telle solution, d'obtenir un gradient thermique élevé à l'équilibre thermique, tout en s'affranchissant des problèmes d'encombrement volumique liés au stockage du réactif de la réaction chimique exothermique ou bien au volume important des dissipateurs de chaleur selon l'art antérieur et des problèmes d'apport en énergie pour faire fonctionner le dissipateur de chaleur.

Par ailleurs, la réalisation d'un tel générateur électrique ainsi que sa mise en route sont simplifiées. Il y a, de plus, une réduction considérable de la masse des réactifs mis en jeu, ce qui permet d'augmenter la densité massique d'énergie du générateur électrique par effet thermoélectrique. De plus, le générateur électrique par effet thermoélectrique est autonome en énergie, d'encombrement réduit et énergétiquement optimisé.

Toutefois, l'obtention de telles performances et notamment les performances énergétiques avec un tel générateur électrique reste délicate car de nombreux facteurs liés au fonctionnement de ce générateur doivent être pris en compte pour trouver le point de fonctionnement unique et optimal pour le générateur électrique. En particulier, il est nécessaire d'obtenir :

- un bon couplage chimique entre les deux réactions chimiques, respectivement endothermique et exothermique,
- un bon couplage thermique permettant d'assurer les échanges thermiques depuis la source de chaleur vers le dissipateur de chaleur et
- un bon couplage électrique permettant d'assurer la production de la puissance électrique requise.

Ces trois types de couplage sont, par ailleurs, dépendants les uns des autres.

La réaction de combustion catalytique de l'hydrogène est, par exemple, cinq fois plus énergétique que la réaction de reformage à partir de méthanol. Ainsi, si la réaction de reformage de méthanol est totale, seulement un cinquième de l'hydrogène produit est utilisé pour la réaction de combustion catalytique exothermique.

Par conséquent, pour obtenir un équilibre, il peut être utile de modérer la réaction chimique de combustion catalytique en agissant sur le débit d'air entrant par l'orifice d'entrée additionnel 8. Un déficit ou un excès d'oxygène permet en effet d'abaisser de façon significative le rendement de la réaction de combustion catalytique.

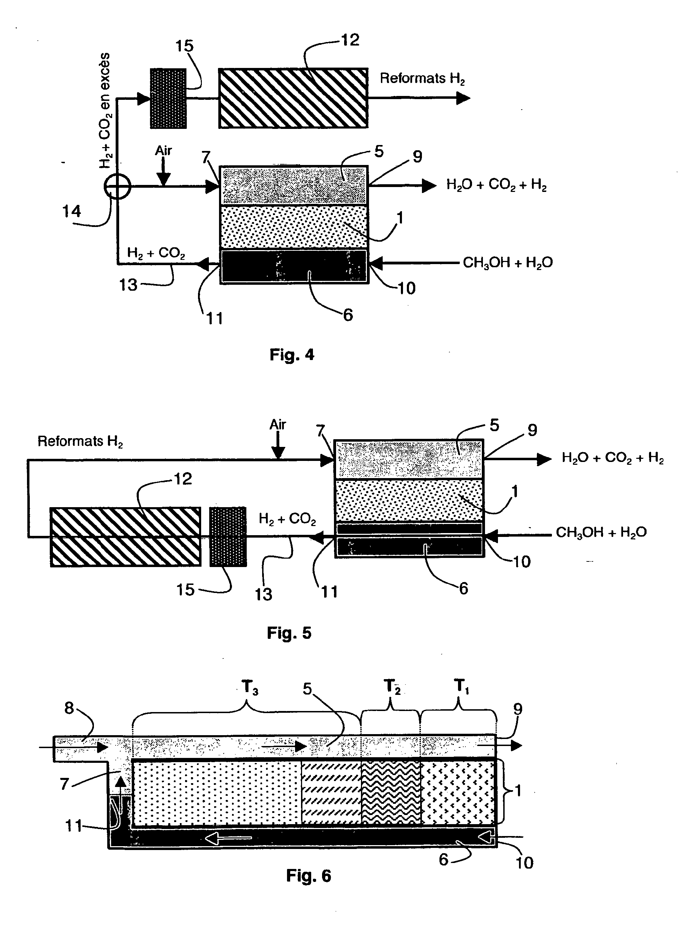

Selon une autre alternative, il est également possible d'associer le convertisseur thermoélectrique à une pile à combustible afin de consommer l'hydrogène produit en excès par la réaction chimique endothermique, après un éventuel filtrage. A titre d'illustration, les figures 4 et 5 représentent des modes de réalisation d'un générateur électrique comprenant une pile à combustible connectée aux moyens d'évacuation du second canal de circulation en vue de récupérer l'hydrogène produit en excès.

En particulier, sur la figure 4, un convertisseur thermoélectrique 1 est disposé entre une chambre de combustion 5 et une chambre de reformage 6. La chambre de reformage 6 comprend une entrée 10 permettant d'alimenter la chambre de reformage en méthanol et en eau et une sortie 11 permettant d'évacuer au moins les produits de reformage, c'est-à-dire principalement de l'hydrogène et du dioxyde de carbone. La sortie 11 est connectée par l'intermédiaire d'un tube d'alimentation 13 à une vanne 14 qui dirige lesdits produits soit vers l'entrée de la chambre de combustion 7, soit vers l'entrée de la pile à combustible 12. Un système de filtration du dioxyde de carbone 15 est, par ailleurs, disposé entre l'entrée de la pile à combustible 12 et la vanne 14. Dans ce mode de réalisation, la pile à combustible utilise, ainsi, l'hydrogène produit en excès par la chambre de reformage et non utile pour la chambre de combustion.

À l'inverse, dans un autre mode de réalisation représenté sur la figure 5, il est possible d'utiliser l'hydrogène non utilisé par la pile à combustible 12 pour alimenter la chambre de combustion 5. Ainsi, la pile à combustible 12 est, dans ce cas, disposée entre l'entrée 7 de la chambre de combustion 5 et la sortie 11 de la chambre de reformage 6, afin de récupérer l'hydrogène non consommé par la pile à combustible 12 et provenant initialement de la chambre de reformage 6.

Selon un autre développement de l'invention, le générateur électrique peut comporter d'autres éléments que la pile à combustible. Il peut, par exemple, comporter une série de micro-turbines disposées avant l'entrée du dissipateur de chaleur, afin de récupérer l'énergie mécanique produite par la circulation des réactifs de la réaction chimique endothermique. L'ajout de cette série de microturbines peut permettre d'augmenter le rendement énergétique du générateur électrique.

Par ailleurs, au niveau de la réaction chimique endothermique, il est préférable d'utiliser une température basse de reformage afin de garantir un gradient thermique le plus élevé possible entre les zones chaude et froide du convertisseur thermoélectrique. Ceci peut, par exemple, être obtenu en contrôlant le rapport vapeur sur carbone également noté S/C et connu sous le nom anglo-saxon « steam to carbon ». Dans le cas du méthanol, il pourrait être possible de réaliser la réaction de vaporeformage à 50°C avec un rapport S/C de 4 à 5. Cependant, à 50°C, la réaction de vaporeformage produit également du monoxyde de carbone. Or, ce produit peut être néfaste, notamment lorsque le générateur comporte une pile à combustible. Ainsi, la réaction de vaporeformage du méthanol est, avantageusement, réalisée avec des températures de reformage comprises entre 200°C et 400°C et avantageusement entre 250°C à 300°C.

Il apparaît également que le principal paramètre permettant d'obtenir un bon point de fonctionnement est la conductivité thermique du convertisseur thermoélectrique. Or, pour pouvoir contrôler ce paramètre afin d'assurer le bon fonctionnement du dispositif et donc trouver le meilleur compromis pour générer une puissance électrique suffisante, il faut s'assurer :

1) que la température $T_c$ dans la chambre de combustion est maximale (750 - 800°C pour une réaction de combustion catalytique de l'hydrogène couplée avec une réaction de vaporeformage du méthanol), afin d'obtenir un gradient thermique très élevé et donc une puissance électrique délivrée maximale,

2) que la température $T_f$ dans le dissipateur de chaleur est minimale afin d'assurer le bon fonctionnement de celle-ci et maximiser le rendement de la réaction. Par exemple, $T_f$ est de l'ordre de 200°C à 400°C dans le cas du vaporeformage à partir du méthanol couplé avec une réaction de combustion catalytique de l'hydrogène,

3) que la source de chaleur et le dissipateur de chaleur présentent des dimensions (taille des canaux, catalyseur,...) permettant pour chacun des éléments d'obtenir un rendement de réaction le plus grand possible et

4) que le convertisseur thermoélectrique est dimensionné thermiquement.

Contrairement à la source de chaleur et au dissipateur de chaleur, le convertisseur thermoélectrique ne peut pas être dimensionné uniquement en tenant compte de ses performances propres. Il est, en effet, pas possible de chercher à obtenir une puissance électrique délivrée maximale, avec un taux de remplissage maximum et une faible hauteur de thermoéléments afin de diminuer la résistance interne du convertisseur. Le convertisseur thermoélectrique est, en effet, dépendant de la source de chaleur et du dissipateur de chaleur, car il est en contact physique avec ces deux éléments. Il est donc nécessaire que sa conductivité thermique soit dimensionnée afin que, pour une valeur de $T_c$ fixée à une température prédéfinie (par exemple entre 700°C et 800°C) et pour une quantité d'énergie absorbée prédéterminée par la réaction endothermique, la valeur de $T_f$ soit maintenue à une température prédéterminée (par exemple comprise entre 200°C et 400°C dans le cas du vaporeformage à partir du méthanol couplé avec une réaction de combustion catalytique de l'hydrogène).

En résumé, le convertisseur thermoélectrique doit être conçu d'un point de vue dimensionnel, afin d'obtenir un compromis entre la conductivité thermique optimale, qui permet d'assurer le bon fonctionnement du dispositif, et la puissance électrique délivrée par le dispositif. Il est, plus particulièrement, dimensionné thermiquement pour répondre aux formules suivantes :

$$\phi_{conduction} = \phi_{froid} - \phi_{SeebeckFroid} - \phi_{joule}$$

$$\phi_{conduction} = \phi_{chaud} - \phi_{SeebeckChaud} + \phi_{joule}$$

dans laquelle :

- $\phi_{conduction}$ est le flux thermique traversant le convertisseur thermoélectrique depuis la première zone vers la seconde zone,
- $\phi_{froid}$ et $\phi_{chaud}$ sont les flux thermiques respectivement absorbés par la réaction chimique endothermique et par la réaction chimique exothermique
- $\phi_{SeebeckChaud}$ et $\phi_{SeebeckFroid}$ sont les flux thermiques Seebeck respectivement au niveau de la zone (4a) en contact avec la source de chaleur et au niveau de la zone (4b) en contact avec le dissipateur de chaleur et, plus particuliè-rement, soit $\phi_{SeebeckChaud} = N.S.I.T_c$ et $\phi_{SeebeckFroid} = N.S.I.T_f$ avec N correspondant au nombre de thermoéléments constituant le générateur thermoélectrique, S correspondant au coefficient Seebeck du matériau, I étant le courant traversant les thermoéléments et $T_f$ et $T_c$ sont respectivement les températures au niveau des zones 4a et 4b, et
- $\phi_{joule}$ est le flux thermique produit par effet Joule dans le convertisseur thermoélectrique.

À titre d'exemple, pour un débit de 250g/h de méthanol et d'eau (soit $\phi_{endo}$ = 90 W/cm$^2$), pour un taux de remplissage (surface du convertisseur / surface cumulée des thermoéléments) de 50%, et une valeur de $T_c$ régulée à 700°C (via le rendement de la réaction exothermique), il faut que l'épaisseur des thermoéléments soit comprise entre 0.8 mm et 1.5 mm, de telle sorte que $T_f$ soit compris entre 200°C et 400°C.

La nature du ou des matériaux formant les thermoéléments 2a et 2b du convertisseur thermoélectrique 1 sont avantageusement choisis en fonction de la gamme de température envisagée, tant pour la zone chaude que pour la zone froide. Ainsi, les thermoéléments 2a et 2b peuvent être en SiGe si la réaction chimique endothermique est une réaction catalytique de vaporeformage du méthanol et la réaction chimique exothermique est une réaction de combustion catalytique de l'hydrogène. En effet, SiGe possède les meilleures performances thermoélectrique dans la gamme de température envisagée pour ce couple de réactions chimiques, c'est-à-dire une température maximale de la zone chaude ($T_c$ = 900°C) et une température minimale de la zone froide ($T_f$ de l'ordre de 150°C), avec une température moyenne entre les zones chaude et froide de l'ordre de 525°C.

À titre d'exemple, dans le cas d'un convertisseur thermoélectrique à base de SiGe et en utilisant le reformage du méthanol pour absorber l'énergie de combustion du coté froid et produire de l'hydrogène, la densité d'énergie électrique maximale théorique $E_{elec}^{max}$ est égale à 38 Wh/kg(méthanol+eau), avec $T_c$ = 800°C et $T_f$ = 300°C. De plus, en utilisant un convertisseur thermoélectrique à base de SiGe nanostructuré, il est possible d'envisager obtenir une densité d'énergie de l'ordre de 60 Wh/kg.

D'autres matériaux thermoélectriques peuvent aussi être utilisés, comme l'alliage $Bi_2Te_3$. En particulier, cet alliage peut être utilisé en combinaison avec l'alliage SiGe afin de former des segments dans le module, le segment formé par des couples de thermoéléments 2a et 2b en $Bi_2Te_3$ est, avantageusement, disposé dans la zone où la température $T_c$ est plus faible.

Avantageusement, si le réactif principal de la réaction chimique endothermique est sous forme liquide, comme c'est le cas pour l'ammoniac, le méthanol ou l'éthanol en mélange avec de l'eau, l'énergie endothermique de vaporisation desdits réactifs, avant la réaction chimique endothermique de vaporeformage proprement dite peut être récupérée, afin d'obtenir un meilleur refroidissement du coté froid du convertisseur thermoélectrique 1. De plus, le convertisseur thermoélectrique 1 peut avantageusement comporter au niveau de l'entrée du second canal de circulation 7 et la sortie du premier canal de circulation 6, une zone formée par un matériau purement conducteur thermiquement, sans thermoélément, afin d'optimiser les bilans énergétiques.

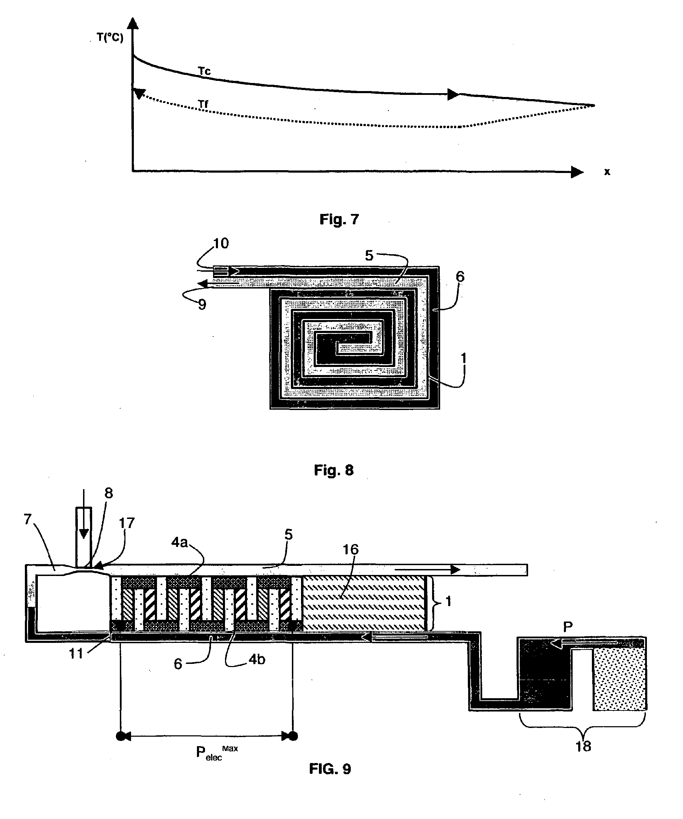

À titre d'exemple et comme illustré sur les figures 6 et 7, le convertisseur thermoélectrique 1 peut comporter, à la place d'un seul type de couples de thermoéléments, au moins deux couples distincts de thermoéléments, afin de définir différentes zones d'échange thermique entre les premier et second canaux de circulation 5 et 6. En particulier, sur la figure 6, le convertisseur thermoélectrique 1 comporte 3 zones, $T_1$, $T_2$ et $T_3$, dont les performances optimales (facteur de mérite maximum) correspondent à la gamme de température en régime permanent (Figure 7). À titre d'exemple, le convertisseur thermoélectrique 1 comporte une zone $T_1$ disposée au niveau de l'entrée du second canal de circulation 6 et de la sortie 9 du premier canal de circulation 5. Cette zone $T_1$ est, avantageusement, une zone permettant l'évaporation des réactifs liquides pour la réaction chimique endothermique. Dans ce cas, cette zone ne comporte pas de thermoéléments, mais est constituée par un matériau thermiquement conducteur. Elle est disposée à côté d'une zone $T_2$, destinée au préchauffage desdits réactifs une fois ceux-ci vaporisés et constituée aussi par un matériau thermiquement conducteur. Dans un mode de réalisation alternatif, les zones $T_1$ et $T_2$ peuvent être confondues. Une zone $T_3$ pouvant contenir au moins deux types de thermoéléments, par exemple en $Bi_2Te_3$ pour les températures faibles, au voisinage de la zone $T_2$ et en SiGe pour les hautes températures lorsque le mélange réactionnel se dirige vers l'orifice de sortie 11 du second canal de circulation.

De plus, les thermoéléments 2a et 2b peuvent être formés par des matériaux thermoélectriques nanostructurés, favorisant la diffusion des phonons aux interfaces entre les nanoagrégats, ce qui permet de réduire considérablement leur conductivité thermique et par la même occasion d'améliorer leurs performances thermoélectriques.

Les premier et second canaux de circulation ne sont pas nécessairement rectilignes comme ceux représentés sur les figures 2 et 6. Ils peuvent être sous une autre forme. À titre d'exemple et comme illustré sur la figure 8, ils peuvent être configurés sous une forme en colimaçon. Une telle forme est avantageuse, car elle permet de limiter les fuites thermiques. Le point le plus chaud du générateur étant au centre du colimaçon, il est donc isolé de l'extérieur. Une autre forme possible concerne la configuration de type toroïdale. De même, la source de chaleur et le dissipateur de chaleur peuvent être formés par un ensemble de canaux ou de microcanaux agencés selon une géométrie dite de type « constructal », dont la surface est recouverte par le catalyseur et destinée à améliorer les échanges thermiques. Des géométries de type arborescent peuvent aussi être utilisées.

Le second canal de circulation 5 formant le dissipateur de chaleur peut, avantageusement, être remplacé par tout autre moyen permettant de réaliser la réaction chimique endothermique, dans la mesure où il permet de rediriger au moins un des produits de la réaction chimique endothermique vers la source de chaleur, afin que le produit de la réaction chimique endothermique puisse être utilisé comme réactif de la réaction chimique exothermique. A titre d'exemple, le second canal de circulation 6 peut être remplacé par une couche mince poreuse, par exemple en alumine ou en nickel, comprenant une pluralité de pores, avantageusement de dimension micrométrique et recouverts par un revêtement catalytique pour la réaction chimique endothermique. Le dépôt du catalyseur peut dans ce cas être réalisé par une technique d'impression, telle que la technique d'impression par jet d'encre ou par des techniques de dépôt en phase vapeur. Il en est de même pour le premier canal de circulation 5.

L'introduction des réactifs de la réaction chimique endothermique peut aussi être réalisée par tout type de moyens approprié. Par exemple, il est possible d'utiliser une pompe en vue d'injecter les réactifs lorsqu'ils sont liquides. Une autre solution peut aussi consister à utiliser la chaleur dégagée par la réaction chimique exothermique pour le pompage de réactifs lorsque ceux-ci sont liquides. À titre d'illustration, on peut utiliser une technique dite de pompage capillaire consistant à faire évaporer dans un tube capillaire le liquide à pomper. À l'interface liquide-gaz, il se forme alors un ménisque générant une pression destinée à aspirer le liquide. Dans le cas de réactifs gazeux, si le gaz est sous pression (par exemple dans le cas de butane), cette pression peut être utilisée pour alimenter le dissipateur de chaleur en réactif, par exemple à l'aide d'un injecteur entraînant également d'autres fluides.

L'introduction des réactifs de la réaction chimique exothermique peut aussi être réalisée par tout type de moyens connus, dès lors qu'une partie au moins du produit obtenu par la réaction chimique endothermique peut être redirigée vers la source de chaleur pour servir de réactif à ladite réaction exothermique. Ainsi, l'emploi d'une mini-pompe classique en vue d'injecter des réactifs gazeux peut être envisagée. Il est, aussi, possible d'utiliser une pompe par effet venturi, au niveau des canaux de distribution de l'hydrogène ou bien un compresseur de type « Knudsen ».

Le générateur électrique par effet thermoélectrique peut être réalisé par exemple par des techniques de dépôts de couches minces utilisées dans le domaine de la microélectrique et qui présentent l'avantage d'offrir une grande densité de thermoéléments et donc d'énergie électrique. Il peut aussi être obtenu par des techniques plus traditionnelles, comme par exemple par au moins une étape de moulage par injection de poudre ou PIM, plus particulièrement à partir de poudres de dimension nanométrique (technique également appelée microPIM), ou par le frittage de matériaux thermoélectriques ou par brasure.

En particulier, la technique dite « PIM » ou « microPIM » permet, en effet, de réaliser, avantageusement en une seule étape, des pièces formées par différents types de matériaux, tels que des métaux, des matériaux céramiques,..., avec des motifs complexes, tout en étant peu coûteuse afin de réaliser une production en grande série. De plus, le procédé « PIM » ou « microPIM » permet de mélanger différents matériaux, afin de réaliser une co-injection. En particulier, il est possible de réaliser une matrice en matériau faiblement conducteur électriquement, tel que l'oxyde de silicium poreux destinée à former le support mécanique des thermoéléments, avec des matériaux thermoélectriques sous forme de poudres lors d'une même opération. Les canaux de circulation des fluides et le dépôt des catalyseurs peuvent également être réalisés par cette même technique. Ainsi, il est possible d'intégrer dans une même plaque :

- les canaux de distribution de fluide
- les thermoéléments
- un échangeur gaz-gaz
- un vaporisateur de fluide
- une pompe capillaire

Le système complet peut comprendre plusieurs plaques et l'assemblage (géométrie droite ou en colimaçon) peut se faire lors d'une étape finale de frittage.

Selon un exemple particulier de réalisation, un générateur électrique tel que représenté sur la figure 9 a été réalisé avec un convertisseur thermoélectrique 1 comprenant des thermoéléments en SiGe, disposés sur un support mécanique réalisé en oxyde de silicium et dont les caractéristiques thermoélectriques sont optimales pour une température moyenne $T_m$ entre les zones chaude et froide de 600°C, avec :

- $\lambda$ = 1.5 W/mK,
- p = 2.5 m$\Omega$.cm et
- et S = 400 $\mu$V/K

où $\lambda$ est la conductivité thermique du convertisseur, p est la conductivité électrique et S est le coefficient Seebeck total du convertisseur.

Le générateur comporte une source de chaleur 5, siège d'une combustion catalytique de l'hydrogène et générant des températures $T_c$ comprises entre 750°C et 900°C sur la face chaude du convertisseur thermoélectrique. Elle est, plus particulièrement, constituée par une couche mince en alumine poreuse enduite de carbone platiné.

Il comporte également un dissipateur de chaleur 6, siège d'une réaction de vaporeformage de méthanol, avec une température $T_f$ comprise entre 200°C et 300 °C et pouvant absorber 722 Wh/kg de réactifs au niveau de la face froide du convertisseur thermoélectrique 1. Le dissipateur de chaleur est, plus particulièrement, constitué par une couche mince en alumine poreuse enduite de particules nanométriques de ZnO et de CuO.

Le gradient thermique susceptible d'être obtenu pour ce générateur est de l'ordre de 500°C à 600°C aux bornes du convertisseur. De plus, le convertisseur thermoélectrique 1 comprend un évaporateur 16 disposé au niveau de l'entrée en réactifs du dissipateur de chaleur 6. Une pompe venturi 17 est également disposée entre la sortie du dissipateur de chaleur 6 et l'entrée de la source de chaleur 5, afin d'alimenter la source de chaleur 5 en air et un réservoir 18 en réactifs est disposé en amont du dissipateur de chaleur 6.

Il est à noter que, pour un tel générateur électrique, le flux froid est limité par la limite d'évaporation de l'eau. En effet, au-delà du régime de caléfaction de l'eau (vers 100 W/cm$^2$), le réservoir en réactifs liquides pour le reformage du méthanol est isolé de la source de chaleur 6 par un film d'eau gazeux. Ainsi, la quantité maximale d'énergie absorbable par le réservoir 18 en réactifs liquides (eau+méthanol) est de l'ordre de 150 W/cm$^2$. La densité de puissance maximale d'un tel générateur est donc de l'ordre de 7.5 W/cm$^2$, ce qui est supérieur aux piles à combustible.

Les paramètres du générateur électrique selon la figure 9 sont répertoriés dans le tableau ci-dessous.

**Tableau 3**

| Paramètres | Unités | Valeur |
|---|---|---|
| Température zone chaude Tc | K | 1073 |
| Température zone froide Tf | K | 573 |
| Hauteur des thermoéléments H | M | variable |
| Surface de la source chaude Ahs | M$^2$ | 1,00$^E$-04 |
| Surface totale du convertisseur thermoélectrique Ate | M$^2$ | 1,00$^E$-04 |
| Surface totale des thermoéléments Anp | M$^2$ | 4,00$^E$-06 |
| Conductivité thermique de la matrice en SiO$_2$ kSiO$_2$ | W/m/K | 0,08 |
| Conductivité thermique des thermoéléments Knp | W/m/K | 3 |
| Coefficient Seebeck d'un thermoélément de type n Sn | V/K | -4,00$^E$-04 |
| Coefficient Seebeck d'un thermoélément de type p Sp | V/K | 4,00$^E$-04 |
| Nombre de jonctions N | | 25 |
| Résistivité électrique des thermoéléments Rho | Ohm.m | 5,00$^E$-05 |
| Largeur du thermoélément Ith | M | 1,00$^E$-03 |

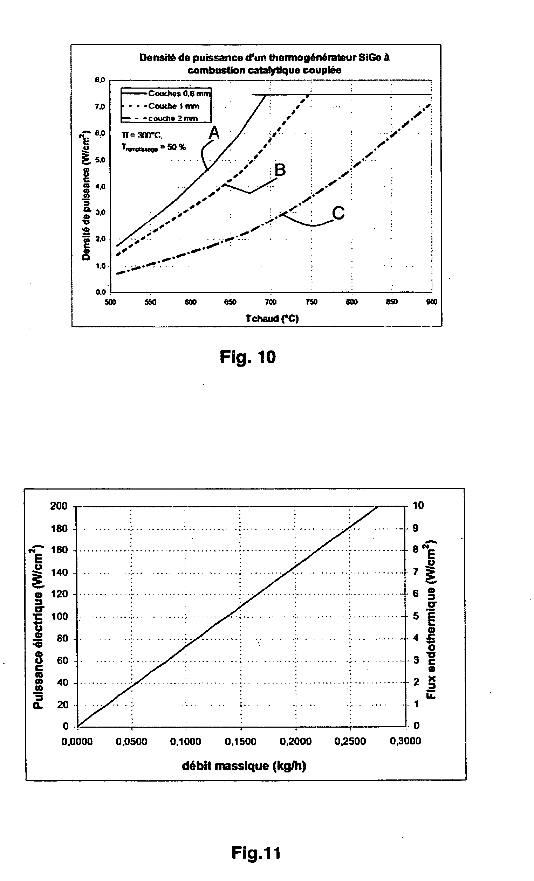

Comme illustré sur la figure 10, la densité de puissance de générateurs tels que celui représenté sur la figure 9 a été mesurée en fonction de la température $T_c$, pour trois hauteurs de thermoéléments : 0.8 mm (courbe A), 1 mm (courbe B) et 2 mm (courbe C), afin de dimensionner thermiquement le convertisseur en fonction des températures de fonctionnement (à la fois $T_c$ et $T_f$), afin de maximiser la densité de puissance et éviter le régime de caléfaction. Ainsi, pour le convertisseur étudié (avec un taux de remplissage des thermoéléments de l'ordre de 50%), les thermoéléments doivent avoir une hauteur de 1 mm pour obtenir une $T_c$ de l'ordre de 750°C. Pour d'autres configurations de convertisseurs thermoélectriques (avec des taux de remplissage moins élevé, avec d'autres matériaux, et d'autres arrangements géométriques), il serait nécessaire de revoir le dimensionnement thermique dudit convertisseur, afin que le flux de conduction $\phi_{conduction}$ à travers le convertisseur thermoélectrique répondent aux deux formules ci-dessous:

$$\phi_{conduction} = \phi_{froid} - \phi_{SeebeckFroid} - \phi_{joule}$$

$$\phi_{conduction} = \phi_{chaud} - \phi_{SeebeckChaud} + \phi_{joule}$$

De plus, sur la figure 11, la puissance électrique délivrée pour le générateur électrique selon l'exemple ci-dessus ainsi que le flux endothermique ont été évalués en fonction du débit massique des réactifs liquides pour la réaction chimique endothermique. La densité de puissance maximale (150 W/cm$_2$) est obtenue pour un débit de 200 g/h de réactifs liquides. Ceci permet d'évaluer la densité massique d'énergie électrique du générateur : $E^{elec}_{max}$ = 40 Wh/kg(méthanol+eau).

**Revendications**

**1.** Générateur électrique par effet thermoélectrique comprenant au moins :

- une source de chaleur (5), siège d'une réaction chimique exothermique et comprenant des moyens d'alimentation en au moins un réactif (7) de ladite réaction chimique exothermique,
- un dissipateur de chaleur (6), siège d'une réaction chimique endothermique et comprenant des moyens d'évacuation d'au moins un produit (11) de la réaction chimique endothermique,
- et un convertisseur thermoélectrique (1) muni d'au moins deux zones (4a, 4b) respectivement en contact avec la source de chaleur (5) et le dissipateur de chaleur (6),
**caractérisé en ce que** les moyens d'alimentation (7) de la source de chaleur (5) sont connectés aux moyens d'évacuation (11) du dissipateur de chaleur (6), ledit produit de la réaction chimique endothermique formant ledit réactif de la réaction chimique exothermique.

2. Générateur selon la revendication 1, **caractérisé en ce que** la source de chaleur (5) et le dissipateur de chaleur (6) sont respectivement formés par au moins des premier et second canaux de circulation.

3. Générateur selon la revendication 2, **caractérisé en ce que** les premier et second canaux de circulation présentent des axes longitudinaux parallèles et **en ce que** le convertisseur électrique (1) est interposé entre les premier et second canaux de circulation.

4. Générateur selon la revendication 3, **caractérisé en ce que** les premier et second canaux de circulation sont configurés sous une forme en colimaçon.

5. Générateur selon l'une quelconque des revendications 2 à 4, **caractérisé en ce que** les premier et second canaux de circulation sont chacun délimités par une paroi comprenant une surface interne munie d'un revêtement catalytique pour la réaction chimique endothermique ou exothermique respectivement associée au premier ou second canal de circulation.

6. Générateur selon l'une quelconque des revendications 1 à 4, **caractérisé en ce que** le dissipateur de chaleur (6) comprend une couche mince poreuse comprenant une pluralité de pores recouverts d'un revêtement catalytique pour la réaction chimique endothermique.

7. Générateur selon l'une quelconque des revendications 1 à 6, **caractérisé en ce qu'**il comporte une pile à combustible (12) connectée auxdits moyens d'évacuation (11) du dissipateur de chaleur (6).

8. Générateur selon l'une quelconque des revendications 1 à 7, **caractérisé en ce que** le convertisseur thermoélectrique (1) est dimensionné thermiquement pour répondre aux formules suivantes :

$$\phi_{conduction} = \phi_{froid} - \phi_{SeebeckFroid} - \phi_{joule}$$

$$\phi_{conduction} = \phi_{chaud} - \phi_{SeebeckChaud} + \phi_{joule}$$

dans laquelle :

- $\phi_{conduction}$ est le flux thermique traversant le convertisseur thermoélectrique depuis la première zone vers la seconde zone,
- $\phi_{froid}$ et $\phi_{chaud}$ sont les flux thermiques respectivement absorbés par la réaction chimique endothermique et par la réaction chimique exothermique
- $\phi_{SeebeckFroid}$ et $\phi_{SeebeckChaud}$ sont les flux thermiques Seebeck respectivement au niveau de la zone (4a) en contact avec la source de chaleur et au niveau de la zone (4b) en contact avec le dissipateur de chaleur et
- $\phi_{joule}$ est le flux thermique produit par effet Joule dans le convertisseur thermoélectrique.

9. Générateur selon l'une quelconque des revendications 1 à 8, **caractérisé en ce que** le convertisseur thermoélectrique (1) comporte au moins deux couples distincts de thermoéléments.

10. Procédé de mise en oeuvre d'un générateur électrique par effet thermoélectrique selon l'une quelconque des revendications 1 à 9, **caractérisé en ce que** ledit produit de la réaction chimique endothermique formant ledit réactif de la réaction chimique exothermique est de l'hydrogène.

11. Procédé selon la revendication 10, **caractérisé en ce que** la réaction chimique exothermique est une réaction de combustion catalytique de l'hydrogène et **en ce que** la réaction chimique endothermique est une réaction de reformage catalytique.

12. Procédé selon la revendication 11, **caractérisé en ce que** la réaction de reformage catalytique est réalisée à partir de méthanol et d'eau, avec un catalyseur choisi parmi le cuivre, le zinc, l'aluminium, le zirconium et le palladium.

**13.** Procédé selon la revendication 12, **caractérisé en ce qu'**un gradient thermique (ΔT) supérieur à 200°C est maintenu entre les deux zones (4a, 4b) du convertisseur thermoélectrique (1).

**14.** Procédé selon la revendication 13, **caractérisé en ce que** la source de chaleur (5) et le dissipateur de chaleur (6) étant respectivement formés par des premier et second canaux de circulation présentant des axes longitudinaux parallèles, des premier et second mélanges réactionnels circulent respectivement dans les premier et second canaux de circulation, selon des directions opposées.

**15.** Procédé de fabrication d'un générateur électrique par effet thermoélectrique selon l'une quelconque des revendications 1 à 9, **caractérisé en ce qu'**il est obtenu par au moins une étape de moulage par injection de poudre, en particulier de dimension nanométrique.

**Patentansprüche**

**1.** Thermoelektrischer Generator, der zumindest Folgendes umfasst:

- eine Wärmequelle (5), Sitz einer exothermen chemischen Reaktion, die Zuführeinrichtungen aus mindestens einem Reagens (7) dieser exothermen chemischen Reaktion aufweist,
- einen Wärmeverteiler (6), Sitz einer endothermen chemischen Reaktion, der Abzugseinrichtungen aus mindestens einem Produkt (11) der endothermen chemischen Reaktion aufweist,
- sowie einen thermoelektrischen Wandler (1), der mit mindestens zwei Bereichen (4a, 4b) versehen ist, die jeweils mit der Wärmequelle (5) bzw. dem Warmeverteiler (6) in Kontakt sind,
**dadurch gekennzeichnet, dass** die Zuführeinrichtungen (7) der Wärmequelle (5) mit den Abzugseinrichtungen (11) des Wärmeverteilers (6) verbunden sind, wobei das Produkt der endothermen chemischen Reaktion das Reagens der exothermen chemischen Reaktion bildet.

**2.** Generator gemäß Anspruch 1, **dadurch gekennzeichnet, dass** die Wärmequelle (5) und der Wärmeverteiler (6) aus mindestens ersten bzw. zweiten Umlaufkanälen gebildet sind.

**3.** Generator gemäß Anspruch 2, **dadurch gekennzeichnet, dass** der erste und zweite Umlaufkanal parallele Längsachsen aufweisen und dass der elektrische Wandler (1) zwischen dem ersten und zweiten Umlaufkanal angeordnet ist.

**4.** Generator gemäß Anspruch 3, **dadurch gekennzeichnet, dass** der erste und zweite Umlaufkanal spiralförmig ausgebildet sind.

**5.** Generator gemäß einem der Ansprüche 2 bis 4, **dadurch gekennzeichnet, dass** der erste und zweite Umlaufkanal jeweils durch eine Wand mit einer Innenfläche begrenzt sind, die mit einer katalytischen Verkleidung für die endotherme oder exotherme chemische Reaktion versehen ist bzw. mit dem ersten oder zweiten Umlaufkanal verbunden ist.

**6.** Generator gemäß einem der Ansprüche 1 bis 4, **dadurch gekennzeichnet, dass** der Wärmeverteiler (6) eine poröse Dünnschicht mit einer Vielzahl von Poren aufweist, die von einer katalytischen Verkleidung für die endotherme chemische Reaktion bedeckt sind.

**7.** Generator gemäß einem der Ansprüche 1 bis 6, **dadurch gekennzeichnet, dass** er eine Brennstoffzelle (12) umfasst, die mit den Abzugseinrichtungen (11) des Wärmeverteilers (6) verbunden ist.

**8.** Generator gemäß einem der Ansprüche 1 bis 7, **dadurch gekennzeichnet, dass** der thermoelektrische Wandler (1) thermisch so bemessen ist, dass der auf die folgenden Formeln anspricht:

$$\Phi_{Leitung} = \Phi_{kalt} - \Phi_{SeebeckKalt} - \Phi_{Joule}$$

$$\Phi_{Leitung} = \Phi_{warm} - \Phi_{SeebeckWarm} + \Phi_{Joule}$$

wobei:

- $\Phi_{Leitung}$ der den thermoelektrischen Wandler durchquerende Wärmekluss von dem ersten Bereich zu dem zweiten Bereich ist,
- $\Phi_{Kalt}$ und $\Phi_{warm}$ die Wärmeflüsse darstellen, die von der endothermen chemischen Reaktion bzw. der exothermen chemischen Reaktion aufgenommen werden,
- $\Phi_{SeebeckKalt}$ und $\Phi_{SeebeckWarm}$ die Seebeck Wärmeflüsse darstellen, die auf Höhe des Bereichs (4a) in Kontakt mit der Wärmequelle und auf Höhe des Bereichs (4b) in Kontakt mit dem Wärmeverteiler sind, und
- $\Phi_{Joule}$ den Wärmefluss darstellt, der durch die Joule-Wirkung in dem thermoelektrischen Wandler erzeugt wird.

9. Generator gemäß einem der Ansprüche 1 bis 8, **dadurch gekennzeichnet, dass** der thermoelektrische Wandler (1) mindestens zwei unterschiedliche Paare von Thermoelementen umfasst.

10. Verfahren zur Verwendung eines thermoelektrischen Generators gemäß einem der Ansprüche 1 bis 9, **dadurch gekennzeichnet, dass** das Produkt der endothermen chemischen Reaktion, das das Reagens der exothermen chemischen Reaktion bildet, aus Wasserstoff besteht.

11. Verfahren gemäß Anspruch 10, **dadurch gekennzeichnet, dass** die exotherme chemische Reaktion eine katalytische Verbrennungsreaktion des Wasserstoffs ist und dass die endotherme chemische Reaktion eine katalytische Reformierungsreaktion darstellt.

12. Verfahren gemäß Anspruch 11, **dadurch gekennzeichnet, dass** die katalytische Reformierungsreaktion auf Grund von Methanol und Wasser mit einem Katalysator ausgewählt aus Kupfer, Zink, Aluminium, Zirkonium und Palladium durchgeführt wird.

13. Verfahren gemäß Anspruch 12, **dadurch gekennzeichnet, dass** ein Wärmegradient (ΔT) von mehr als 200°C zwischen den zwei Bereichen (4a, 4b) des thermoelektrischen Wandlers (1) aufrechterhalten wird.

14. Verfahren gemäß Anspruch 13, **dadurch gekennzeichnet, dass** die Wärmequelle (5) und der Wärmeverteiler (6) aus dem ersten bzw. zweiten Umlaufkanal gebildet sind, welche parallele Längsachsen darstellen, wobei erste und zweite Reaktionsgemische in dem ersten bzw. zweiten Umlaufkanal in entgegengesetzten Richtungen fließen.

15. Herstellungsverfahren eines thermoelektrischen Generators gemäß einem der Ansprüche 1 bis 9, **dadurch gekennzeichnet, dass** er durch mindestens einen Formschritt durch Einspritzen von Pulver, insbesondere im Nanometerbereich, erhalten wird.

**Claims**

1. Electric generator based on a thermoelectric effect including at least:

   - a heat source (5), center of an exothermic chemical reaction and including means (7) for supplying with at least one reagent of said exothermic chemical reaction,
   - a heat dissipator (6), center of an endothermic chemical reaction and including means (11) for evacuating at least one product of the endothermic chemical reaction,
   - and a thermoelectric converter (1) provided with at least two areas (4a, 4b) respectively in contact with the heat source (5) and the heat dissipator (6), **characterized in that** the means (7) for supplying the heat source are connected to the means (11) for evacuating the heat dissipator, said product of the chemical endothermic reaction forming said reagent of the exothermic chemical reaction.

2. Generator according to claim 1, **characterized in that** the heat source (5) and the heat dissipator (6) are respectively formed by at least first and second circulation channels.

3. Generator according to claim 2, **characterized in that** the first and second circulation channels have parallel longitudinal axes and **in that** the electric converter (1) is interposed between the first and second circulation channels.

4. Generator according to claim 3, **characterized in that** the first and second circulation channels have a spiral configuration.

5. Generator according to any one of the claims 2 to 4, **characterized in that** each of the first and second circulation channels is delimited by a wall including an internal surface provided with a catalytic coating for the endothermic or exothermic chemical reaction respectively associated with the first or second circulation channel.

6. Generator according to any one of the claims 1 to 4, **characterized in that** the heat dissipator (6) includes a porous thin film including a plurality of pores covered with a catalytic coating for the endothermic chemical reaction.

7. Generator according to any one of the claims 1 to 6, **characterized in that** it includes a fuel cell (12) connected to said means (11) for evacuating the heat dissipator (6).

8. Generator according to any one of the claims 1 to 7, **characterized in that** the thermoelectric converter (1) is thermically dimensioned to comply with the following formulas:

$$\phi_{conduction} = \phi_{cold} - \phi_{SeebeckCold} - \phi_{joule}$$

$$\phi_{conduction} = \phi_{hot} - \phi_{SeebeckHot} + \phi_{joule}$$

in which:

- $\phi_{conduction}$ is the heat flux through the thermoelectric converter from the first area to the second area,
- $\phi_{cold}$ and $\phi_{hot}$ are the heat fluxes respectively absorbed by the endothermic chemical reaction and the exothermic chemical reaction,
- $\phi_{SeebeckHot}$ and $\phi_{SeebeckCold}$ are the Seebeck heat fluxes respectively in the area (4a) in contact with the heat source and in the area (4b) in contact with the heat dissipator and
- $\Phi_{joule}$ is the heat flux produced by Joule effect in the thermoelectric converter.

9. Generator according to any one of the claims 1 to 8, **characterized in that** the thermoelectric converter (1) includes at least two distinct couples of thermoelements.

10. Method for implementing an electric generator based on a thermoelectric effect according to any one of the claims 1 to 9, **characterized in that** said product of the endothermic chemical reaction forming said reagent of the exothermic chemical reaction is hydrogen.

11. Method according to claim 10, **characterized in that** the exothermic chemical reaction is a catalytic combustion reaction of hydrogen and **in that** the endothermic chemical reaction is a catalytic reforming reaction.

12. Method according to claim 11, **characterized in that** the catalytic reforming reaction is carried out from methanol and water, with a catalyst selected among copper, zinc, aluminum, zirconium and palladium.

13. Method according to claim 12, **characterized in that** a heat gradient ($\Delta T$) higher than 200°C is maintained between the two areas (4a, 4b) of the thermoelectric converter (1).

14. Method according to claim 13, **characterized in that** as the heat source (5) and the heat dissipator (6) being respectively formed by first and second circulation channels with parallel longitudinal axes, first and second reactional mixtures circulate respectively through the first and second circulation channels, according to opposite directions.

15. Method for manufactoring an electric generator based on a thermoelectric effect according to any one of the claims 1 to 9, **characterized in that** it is obtained by at least one step of powder injection molding, in particular of nanometric size.

Flux chaud

$T_c$

3a  2b  4a

1

2a

$T_f$

3b  4b

Flux froid

**Fig. 1 (Art antérieur)**

8  4a  5  9

7

11

4b  **Fig. 2**  6  10  1

T(°C)

Tc

Tf

x

**Fig. 3**

**Fig. 4**

**Fig. 5**

**Fig. 6**

**Fig. 7**

**Fig. 8**

**FIG. 9**

**Fig. 10**

**Fig.11**

## RÉFÉRENCES CITÉES DANS LA DESCRIPTION

**Documents brevets cités dans la description**

- US 6313393 B
- US 2008113233 A